Europäisches Patentamt

European Patent Office

Office européen des brevets

(19)

(11) Publication number : **0 498 736 A2**

## (12) EUROPEAN PATENT APPLICATION

(21) Application number : **92400328.8**

(22) Date of filing : **07.02.92**

(51) Int. Cl.⁵ : **H01S 3/085,** H01S 3/19, H01L 33/00

(30) Priority : **08.02.91 JP 37845/91**

(43) Date of publication of application :
**12.08.92 Bulletin 92/33**

(84) Designated Contracting States :
**DE FR GB**

(71) Applicant : **FUJITSU LIMITED**
**1015, Kamikodanaka Nakahara-ku**
**Kawasaki-shi Kanagawa 211 (JP)**

(72) Inventor : **Shoji, Hajime, c/o Fujitsu Limited**
**1015, Kamikodanaka, Nakahara-ku**
**Kawasaki-shi, Kanagawa 211 (JP)**

(74) Representative : **Joly, Jean-Jacques et al**
**CABINET BEAU DE LOMENIE 55, rue**
**d'Amsterdam**
**F-75008 Paris (FR)**

(54) **Dfb laser diode having a modified profile of linewidth enhancement factor.**

(57) A distributed feedback laser diode comprises an active layer (13), a waveguide layer (12), a corrugation grating (11a) for causing a Bragg reflection of an optical beam, and a phase shift point (11A) provided in the corrugation grating. The active layer is formed of a first region (13A), a second region (13B) and a third region (13C) aligned in a longitudinal direction such that the first region and third region are located at both sides of the second region in the first direction, wherein the first region, the second region and the third region have first, second and third profiles of the linewidth enhancement factor respectively such that the linewidth enhancement factor of the second profile is smaller than the linewidth enhancement factor of the first and third profiles and the linewidth enhancement factor changes stepwise at a boundary between the first region and the second region and at a boundary between the second region and the third region.

FIG. 8

BACKGROUND OF THE INVENTION

The present invention generally relates to semiconductor devices and more particularly to a DFB laser diode having a capability of shifting its oscillation frequency in a wide frequency range.

In the high speed, large capacity optical telecommunication systems, laser diode is an essential device for producing the coherent optical beam. Particularly, the laser diode is required to oscillate at a single frequency with a narrow spectrum. Further, in order to deliver information as a modulated optical beam, it is necessary that the laser diode has a capability of shifting its frequency in response to an electric information signal. Thereby, the frequency-shift keying (FSK) modulation of optical beam is achieved. Further, such a tunable laser diode is useful in realizing a frequency multiplex telecommunication system.

As a laser diode for use in such optical telecommunication systems, a tunable DFB laser diode is proposed in the Japanese Patent Applications 1-184144, 1-235929, 1-235930 and 1-235928 that correspond to the United States Patent Application S.N.552,116 and the European patent application No.90307626.3, which are incorporated herein as reference.

In the DFB laser diode of the above proposal, a non-uniform intensity profile of optical radiation is induced in the laser diode along a longitudinal axis thereof such that a maximum of radiation intensity occurs generally in correspondence to the longitudinal center of the laser diode. By injecting a modulation current selectively in correspondence to the maximum of the radiation that in turn corresponds to the maximum depletion of carriers, one can change the oscillation frequency of the laser diode in a wide range of frequency. In this conventional DFB laser diode, the non-uniform radiation profile is artificially induced by providing a λ/4-shift point generally at the longitudinal center of the corrugation grating that is provided for establishing the Bragg reflection in the DFB laser diode. Such a strong depletion of carriers caused at the longitudinal center of the laser diode in response to the strong optical radiation is called "axial hole burning effect."

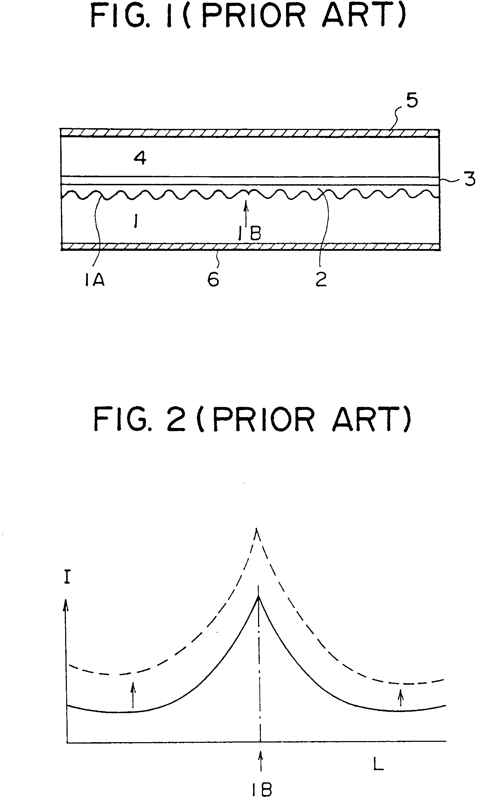

FIG.1 shows the simplified structure of a conventional DFB laser diode having the λ/4 phase shift point in the corrugation grating of the waveguide layer. In such a conventional DFB laser diode, the inventor of the present invention has found that the magnitude of frequency shift obtained as a result of the modulation of the injection current is not as large as expected from the change of the injection current. Hereinafter, this problem will be examined in detail with reference to FIGS.1 - 4. For the sake of simplicity, the explanation will be given for the device of FIG.1 that has only one electrode in the longitudinal direction.

Referring to FIG.1, the conventional DFB laser diode has a substrate 1 of an n-type compound semiconductor material such as InP, and a waveguide layer 2 of another n-type compound semiconductor material is provided on the substrate 1. At the interface between the substrate 1 and the waveguide layer 2, a corrugation grating 1A is provided for causing the Bragg reflection. In correspondence to the longitudinal center of the corrugation grating, there is provided a λ/4-phase shift point 1B for causing the concentration of optical radiation at the longitudinal center of the laser diode. At the λ/4-phase shift point 1B, the continuous repetition of corrugation grating is discontinued such that the corrugation grating at the right of the point 1B is shifted in phase with respect to the corrugation grating at the left of the point 1B by the phase equal to λ/4, where λ represents the wavelength of the corrugation grating. On the waveguide layer 2, an undoped active layer 3 is provided and a clad layer 4 of p-type compound semiconductor material is provided on the active layer 3. Further, an electrode 5 is provided on the clad layer 4 and another electrode 6 is provided on the lower major surface of the substrate 1.

In operation, a drive current is injected via the electrodes 5 and 6 and there is caused a stimulated emission in the active layer 3. The optical beam thus produced is guided along the waveguide layer 2 while experiencing the periodically changing refractive index profile that is caused by the corrugation grating. Thereby, the optical radiation is reflected back and forth by the Bragg reflection.

FIG.2 shows the intensity distribution of the optical radiation produced in the active layer 3 of the device of FIG.1 in the longitudinal direction. As shown therein by the continuous line, there appears a maximum in the optical intensity distribution in correspondence to the λ/4-shift point 1B.

In correspondence to the optical intensity distribution of FIG.2, there appears a distribution of the carrier density N as shown in FIG.3, wherein it will be seen that a dip or valley of carrier density is formed in correspondence to the maximum of the optical radiation intensity. Further, in correspondence to the carrier density distribution of FIG.3, there appears a profile of refractive index n in the longitudinal direction of the laser diode as shown in FIG.4.

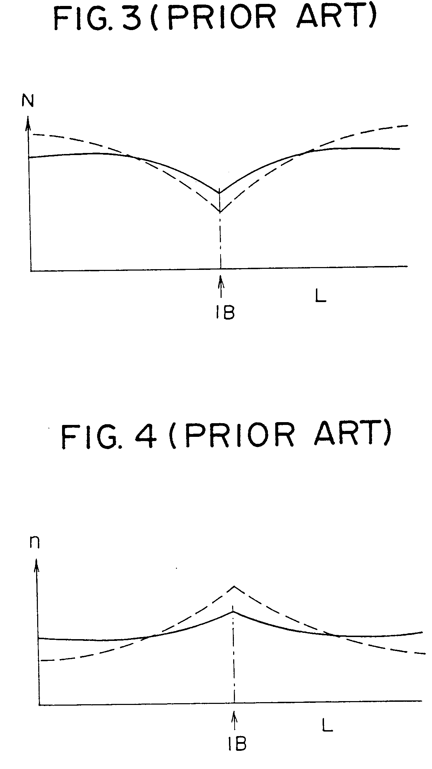

In the meantime, the inventor of the present invention has discovered that the change of the drive current, intended to cause the shift in the carrier density profile and hence the refractive index profile for the frequency shift modulation, does not cause the desired parallel shift of the refraction index profile but a mere modification without substantial shift as shown by the broken lines in FIGS.3 and 4.

More specifically, the increased injection current certainly causes an increased carrier density at both longitudinal ends of the laser diode, while such an increase in the injection current simultaneously causes an enhancement of the depletion of the carriers at the central part corresponding to the λ/4-shift point 1B. It is believed that such a depletion of the carrier is caused as a result of the increased intensity of optical radiation that facilitates the recombination. FIG.4 shows the increased intensity of the optical radiation by the broken line.

As a result of such a decrease in the carrier density at the central part of the laser diode, the overall carrier density that is the carrier density averaged in the longitudinal direction, does not shift as is expected from the increased injection current. This in turn means that the overall or averaged refractive index of the active layer does not change substantially. Only the profile changes as shown in FIG.4 by the broken line. Thereby, one cannot obtain the desired large shift of the oscillation frequency.

SUMMARY OF THE INVENTION

Accordingly, it is a general object of the present invention to provide a novel and useful DFB laser diode, wherein the foregoing problems are eliminated.

Another and more specific object of the present invention is to provide a DFB laser diode capable of shifting the oscillation frequency in a wide frequency range.

Another object of the present invention is to provide a DFB laser diode having a linewidth enhancement factor that is modified in a longitudinal direction of the laser diode, wherein the laser diode includes: a first region located generally in correspondence to the longitudinal center of the laser diode and characterized by a first linewidth enhancement factor; and a second region located at both sides of the first region in the longitudinal direction and characterized by a second linewidth enhancement factor; wherein there is a discontinuity formed between the first and second linewidth enhancement factors at the boundary between the first region and the second region. According to the present invention, one can suppress the shift of the refractive index in the first region, and the canceling out of the overall refractive index shift in the first region and the second region is thereby minimized. Thereby, a change of the refraction index occurs in the entire length of the laser diode and the oscillation frequency of laser diode changes in a wide range of frequency.

Another object of the present invention is to provide a process for fabricating a DFB laser diode that includes, in an active layer thereof, a first region having a first linewidth enhancement factor and a second region disposed at both sides of the first region in a longitudinal direction of the laser diode, said second region having a second linewidth enhancement factor that is different from the first linewidth enhancement factor, wherein the active layer has a multiple quantum well structure with a thickness of each semiconductor layer forming the multiple quantum structure being changed in the first and second regions, comprising the steps of depositing each layer of the quantum well structure using a pair of elongated masks generally extending parallel with each other in the longitudinal direction of the laser diode, said masks being disposed with a predetermined separation in correspondence to the active layer, wherein each mask has a lateral projection area projecting laterally in a direction away from the other mask. According to the present invention, one can increase the rate of growth of the layer forming the multiple quantum well structure by providing the lateral projection area in correspondence to where the first region is to be formed. With the increase in the thickness of the layers that form the multiple quantum well structure in the first region, the wavelength of the optical radiation produced in the correspondence to the first region becomes longer than the wavelength that is produced in the second region where the thickness of the quantum well layer is smaller. As the corrugation of the DFB laser diode is tuned to the optical radiation that is produced in the second region, such a deviation of the wavelength in the first region results in an increase in the differential gain, and such an increase in the differential gain causes a decrease of the linewidth enhancement factor.

Other objects and further features of the present invention will become apparent from the following detailed description when read in conjunction with the attached drawings.

BRIEF DESCRIPTION OF THE DRAWINGS

FIG.1 is a diagram showing the longitudinal cross section of a conventional DFB laser diode;
FIG.2 is a diagram showing the longitudinal profile of optical intensity in the active layer of the laser diode of FIG.1;
FIG.3 is a diagram showing the longitudinal profile of the carrier density in the active layer of the laser diode of FIG.1;
FIG.4 is a diagram showing the longitudinal profile of the refractive index in the active layer of the laser diode of FIG.1;

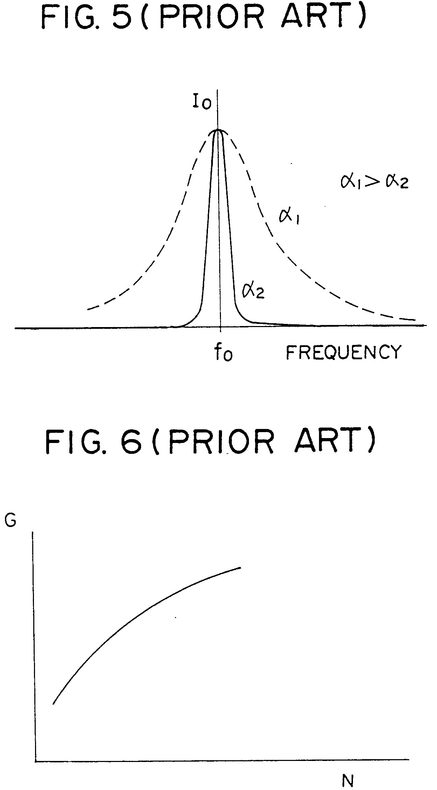

FIG.5 is a diagram showing the relationship between the spectrum of the laser diode and the linewidth enhancement factor;
FIG.6 is a diagram showing schematically the relationship between the gain of the laser diode and the carrier density;

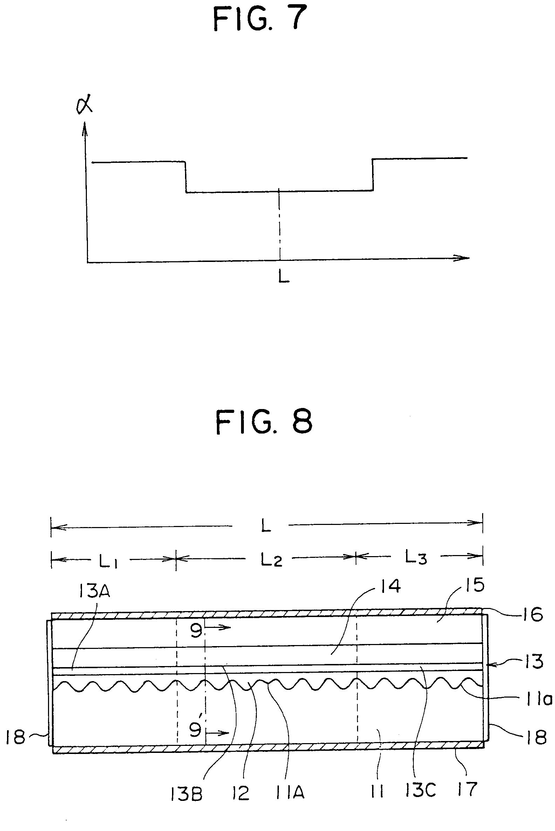

FIG.7 is a diagram showing the longitudinal distribution of the linewidth enhancement factor in the DFB laser diode of the present invention;
FIG.8 is a diagram showing the longitudinal cross section of a DFB laser diode according to a first embodiment of the present invention;

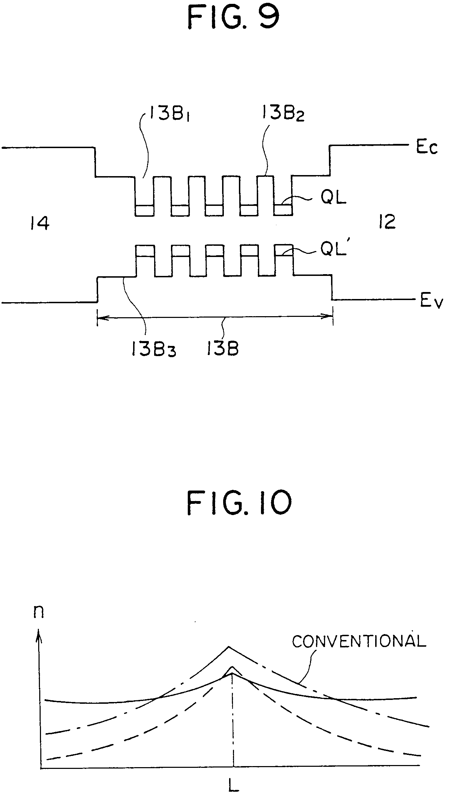

FIG.9 is a diagram showing the band structure of the essential part of the laser diode of FIG.8 taken along a line 9-9';

FIG.10 is a diagram showing the longitudinal profile of the refractive index achieved by the DFB laser diode of FIG.8 together with the profile of FIG.4 for the purpose of comparison;

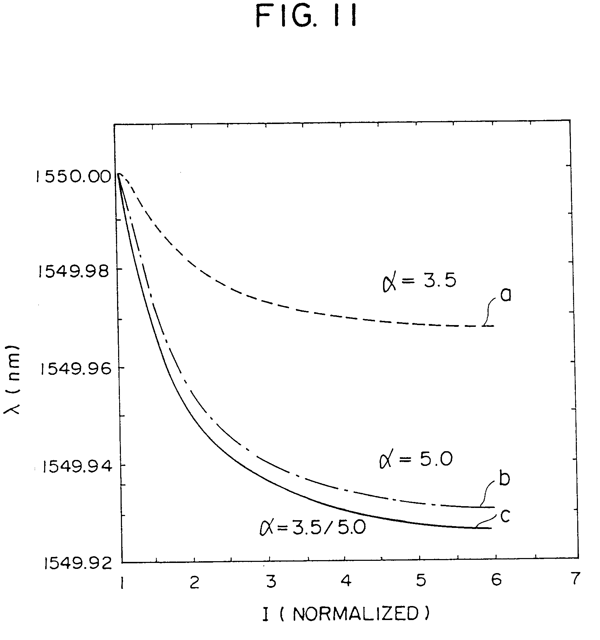

FIG.11 is a diagram showing the relationship between the shift of the oscillation wavelength and the injection current for various DFB laser diodes with various profiles of the linewidth enhancement factor;

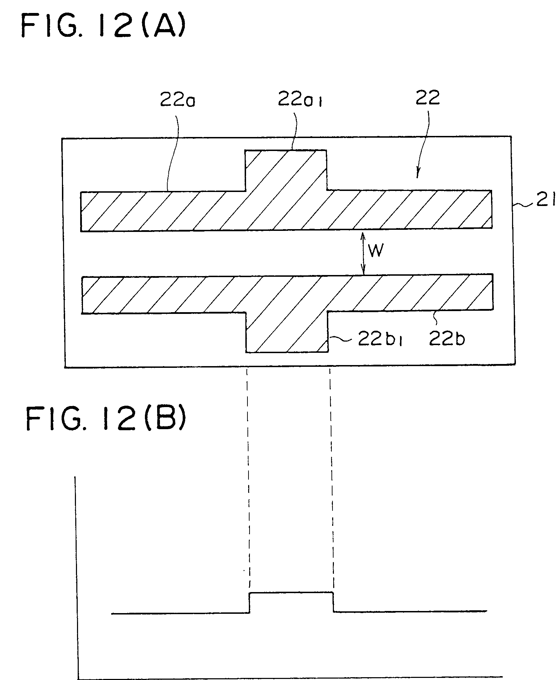

FIGS.12(A) and 12(B) are diagrams showing the principle of the fabrication process that is used for fabricating the DFB laser diode of a second embodiment of the present invention;

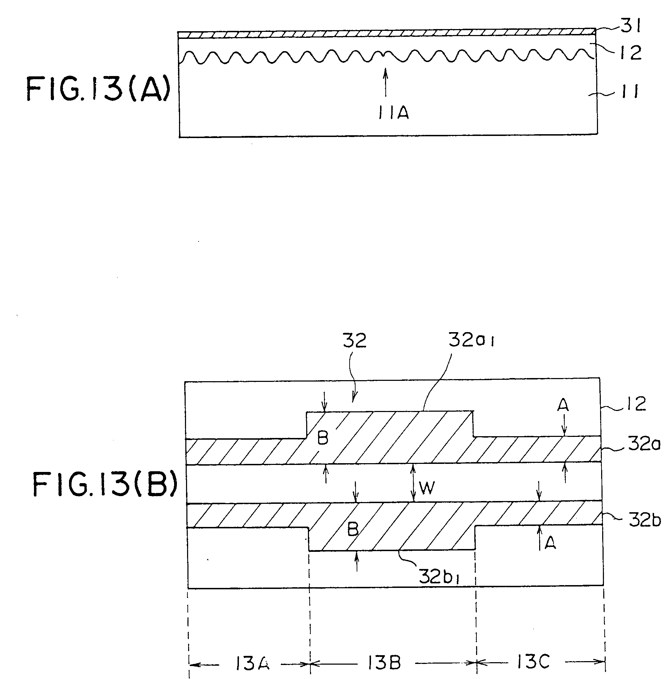

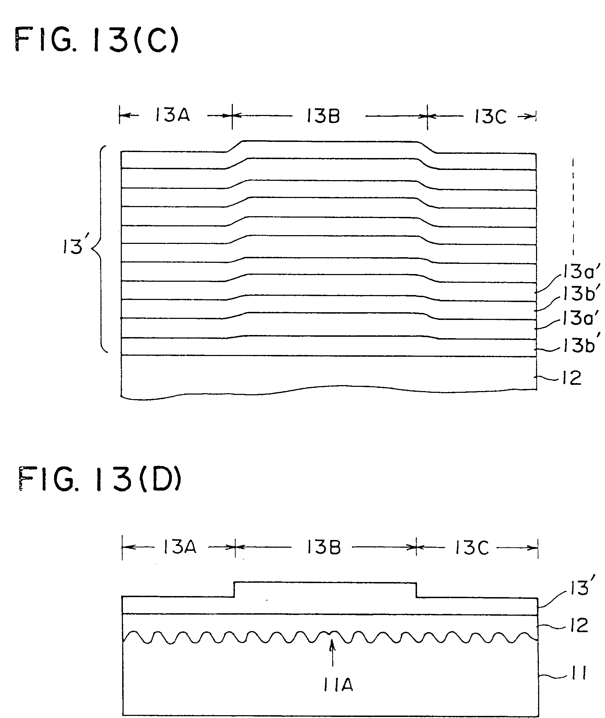

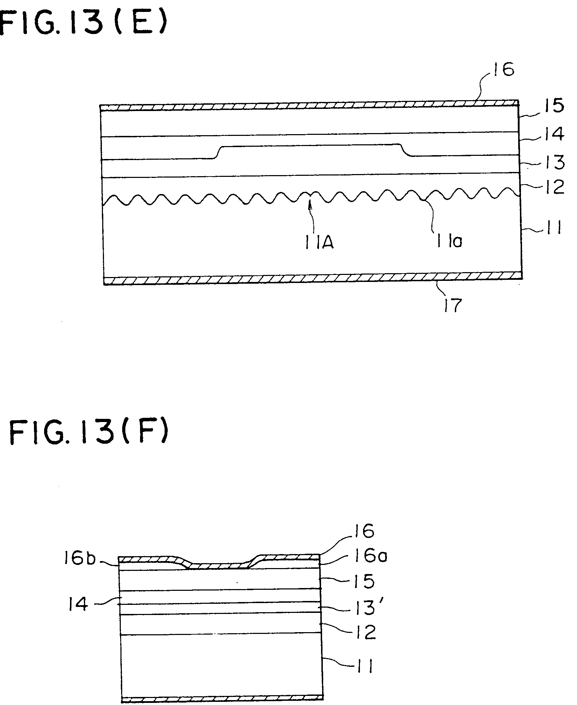

FIGS.13(A) - 13(F) are diagrams showing the process for fabricating the DFB laser diode according to the second embodiment of the present invention;

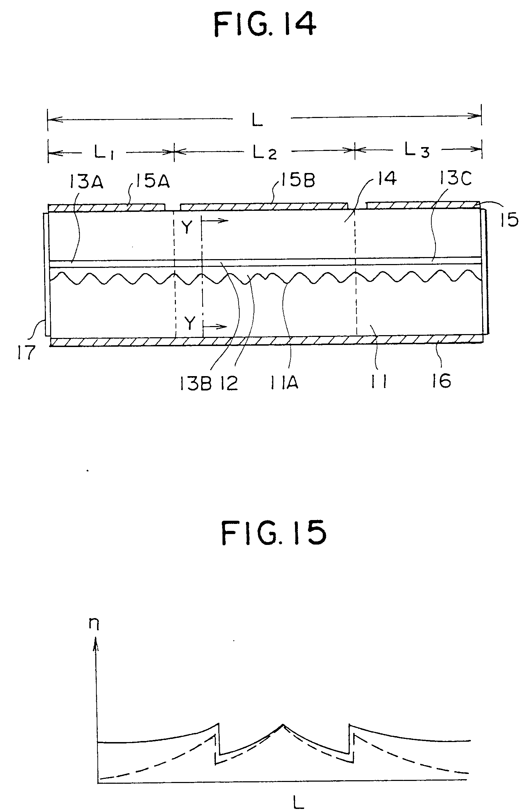

FIG.14 is a diagram showing the longitudinal cross section of the DFB laser diode according to a third embodiment of the present invention; and

FIG.15 is a diagram showing the longitudinal profile of the refractive index realized in the active layer of the laser diode of FIG.14.

## DETAILED DESCRIPTION OF THE PREFERRED EMBODIMENTS

In the description below, the DFB laser diode according to the present invention will be described.

First, the principle of the present invention will be described with reference to FIGS.5 and 6, wherein FIG.5 shows the spectrum of the optical beam produced by a laser diode and FIG.6 shows the relationship between the gain G of the laser diode and the carrier density N that is formed in the active layer of the laser diode.

In the DFB laser diode or laser diode in general, the coherent optical beam is produced as a result of the stimulated emission. In the stimulated emission, it is well known that the emission of photons occurs as a result of interaction between the carriers and the quantized electromagnetic field, and the photons are emitted to the mode that is already occupied by the photons. In other words, the optical beam that propagates back and forth in the active layer induces emission of photons therein with a phase synchronized with the phase of the optical beam. Thereby, the amplification of the coherent optical beam is achieved.

In the laser diode, there exists another mechanism for producing the optical radiation known as the spontaneous emission. In this process, the carriers cause an interaction with a fluctuating quantum field of vacuum, and the emission of photons is made to the mode where there is no or few photons. As a result of the spontaneous emission, the optical radiation produced by the laser diode inevitably shows a broad spectrum due to the random phase and wavelength of the optical radiation produced by this mechanism.

In such a DFB laser diode, there is a quantity called linewidth enhancement factor $\alpha$ that is defined as

$$\alpha \propto (dn/dN)/(dG/dN) \quad (1)$$

wherein the quantity G represents the gain of the laser diode and the term dG/dN represents the differential gain. The linewidth enhancement factor $\alpha$ represents the contribution of the spontaneous emission to the overall radiation formed in the active layer of the laser diode. In other words, the factor $\alpha$ represents the degree of broadening of the spectrum of the laser diode.

FIG.5 shows the spectrum of a typical DFB laser diode for two different values of the linewidth enhancement factor $\alpha$. It will be seen that the spectrum becomes broad when the linewidth enhancement factor $\alpha$ is large ($\alpha = \alpha_1$) while the spectrum becomes sharp when the factor $\alpha$ is small ($\alpha = \alpha_2$). In the conventional DFB laser diode, the linewidth enhancement factor $\alpha$ is generally constant along its longitudinal axis except for a small, gradual decrease at the central part thereof. It should be noted that the term dn/dN is determined by the composition and structure of the active layer of the laser diode, while the term dG/dN does not change significantly in the laser diode.

FIG.6 shows the gain G as a function of the carrier density N. As will be seen, the gain increases generally monotonously with the carrier density N, with the differential gain dG/dN decreasing gradually with the carrier density N. As the carriers are strongly depleted in the longitudinal center of the DFB laser diode, the slope dG/dN increases slightly in this part of the laser diode. This in turn results in the aforementioned slight decrease of the factor $\alpha$. However, this effect is not significant, as the slope of the curve shown in FIG.6 does not change significantly even when the carrier density N is changed.

It should be noted that the change of the refractive index in response to the carrier density is thereby represented approximately as

$$dn \propto \alpha \cdot dN. \quad (2)$$

wherein it is assumed that the term dG/dN is constant. This relationship indicates that one can suppress the change of the refractive index of the active layer by reducing the value of the parameter $\alpha$.

In the present invention, the unwanted increase of the refractive index at the central part of the active layer of the laser diode as shown in FIG.4 is suppressed by modifying the value of the linewidth enhancement factor $\alpha$ in correspondence to the longitudinal center of the laser diode.

FIG.7 shows the principle of the present invention. Referring to FIG.7 showing the longitudinal profile of the linewidth enhancement factor $\alpha$ in the active layer, it will be seen that the factor $\alpha$ is changed stepwise in three distinct parts along the longitudinal direction, i.e. a first part or part I at a first end of the laser diode, a second part or part 11 at a longitudinal center and a third part or part 111 at a second, opposite end, such that the linewidth enhancement factor $\alpha$ is decreased in correspondence to the central part 11. In the first part 1 and the third part 111, the factor $\alpha$ may be the same. By setting the profile of $\alpha$ as such, one can achieve a large overall refraction index change in the laser diode and hence a large frequency shift.

FIG.8 shows the longitudinal cross section of the DFB laser diode according to a first embodiment of the present invention.

Referring to FIG.8, the laser diode is constructed on a substrate 11 of n-type InP, wherein the substrate 11 has a corrugated upper major surface 11a that establishes the Bragg reflection in the longitudinal direction as usual in the art. Further, there is provided a $\lambda/4$-shift point 11A in the corrugation grating 11a generally in correspondence to the central part of the laser diode. Typically, the substrate 11 is doped with an impurity concentration level of $1 \times 10^{18}\text{cm}^{-3}$.

On the substrate 11, there is provided a waveguide layer 12 of n-type InGaAsP having an impurity concentration level of $5 \times 10^{17}\text{cm}^{-3}$. The waveguide layer 12 has a substantially flat upper major surface and has a thickness that changes between 100 nm and 150 nm in correspondence to the peak and valley of the corrugation grating 11A. Further, an active layer 13 is provided on the waveguide layer 12 with a thickness of 150 nm for producing the optical radiation as a result of the stimulated emission. As will be described later in detail, the active layer 13 is formed of three distinct regions 13A, 13B and 13C aligned in the longitudinal direction of the laser diode with longitudinal lengths $L_1$, $L_2$ and $L_3$, wherein the region 13B is located at the longitudinal center. It should be noted that the regions 13A, 13B and 13C correspond respectively to the regions I, II and III of FIG.7, in which the region 13B is formed at the longitudinal center in correspondence to the $\lambda/4$-shift point 11A.

On the active layer 13, there is provided a clad layer 14 of p-type InP having an impurity concentration level of $5 \times 10^{17}\text{cm}^{-3}$ and a thickness of 150 nm. Further, a contact layer 15 of p-type InGaAsP is provided on the clad layer 14 with a thickness of 0.5 $\mu$m. On the contact layer 15, there is provided a p-type electrode layer 16 having a layered structure of Ti/Pt/Au with a thickness of about 1 $\mu$m as usual. Further on the lower major surface of the substrate 11, an n-type electrode layer 17 having a layered structure of AuGe with a thickness of about 1 $\mu$m. Furthermore, a silicon nitride anti-reflection film 18 is provided on both longitudinal ends of the laser diode with a thickness of 200 nm.

Next, the construction of the active layer 13 that forms the essential part of the present invention will be described in detail.

Referring to FIG.8 again, the regions 13A and 13C of the layer 13 are formed of undoped InGaAsP, wherein the length $L_1$ and the length $L_3$ are set to about 300 $\mu$m. On the other hand, the length $L_2$ of the region 13B is set to about 600 $\mu$m. In all, the laser diode has a total longitudinal length L of about 1200 $\mu$m. It should be noted that the regions 13A and 13C are formed of a bulk crystal of InGaAsP while the region 13B has a multiple quantum well (MQW) structure.

FIG.9 shows the band diagram of the region 13B taken along the cross section shown in FIG.8 by a line 9-9′.

Referring to FIG.9, the region 13B includes an alternate repetition of layers $13_{B2}$ and $13_{B2}$, wherein the layer $13_{B1}$ is formed of undoped InGaAs layer having a thickness of 90 nm and acting as a quantum well layer, while the layer $13_{B2}$ is formed of undoped InGaAsP layer having a thickness of 130 nm and acting as a barrier layer. In FIG.9, the conduction band is shown by $E_c$ while the valence band is shown by $E_v$. It will be seen that the layer $13_1$ has a band gap that is substantially smaller as compared with the barrier layer $13_2$ and there is obtained an effective confinement of carriers in the quantum well formed by the layer $13_1$. Further, the MQW structure thus formed of the layers $13_1$ and $13_2$ are sandwiched vertically by a pair of SCH (separate confinement heterostructure) layers $13_{B3}$ of InGaAsP each having a thickness of 265 nm. Typically, the layer unit formed of the layers $13_{B1}$ and $13_{B2}$ is repeated for about five times in the active layer 13.

By forming the MQW structure as such, there are formed discrete quantum levels QL and QL′ in each quantum well as a result of the vertical confinement of the carriers. Thereby, the recombination of carriers occurs selectively and intensively between these quantum levels and the efficiency of stimulated emission is improved substantially. This in turn increases the term of the differential gain dG/dN in Eq.(1) in correspondence to the region 13B. In Eq.(1), the linewidth enhancement factor $\alpha$ decreases with the increase of the term dG/dN.

In operation, the injection current is supplied across the electrodes 16 and 17, and the carriers thus injected are accumulated in the active layer 13 as usual. Thereby, an efficient recombination of carriers occurs when the injection current exceeds a predetermined threshold. As a natural tendency of the DFB laser diode, the intensity of optical beam is enhanced at the longitudinal central part of the laser diode, and this non-uniform profile of the optical intensity is enhanced by the $\lambda/4$-shift point 11A, similarly to the device of FIG.1. Thereby, the carrier profile similar to FIG.3 and characterized by the depletion of carriers at the longitudinal central part of the device is obtained.

FIG.10 shows the refractive index profile that is achieved by the present invention, wherein the continuous line represents the initial state and the broken line represents the state realized in response to the increase of the injection current. For the sake of comparison, the refraction index profile that is achieved by the conventional device of FIG.1 is shown in FIG.10 by a one-dotted chain. It should be noted that the carrier distribution profile substantially identical with that shown in FIG.3 is obtained also in the device of the present embodiment as a result of the axial hole burning. In the device of the present embodiment, the unwanted increase of the refractive index in response to the increase of the injection current at the central part of the laser diode is suppressed in the device of the present embodiment as can be seen clearly in FIG.10. Thereby, there occurs an overall shift of the refractive index in the downward direction in FIG.10 and there occurs a corresponding large shift of the oscillation wavelength.

FIG.11 shows the shift of the oscillation wavelength in response to the change of the injection current. In FIG.11, the vertical axis represents the oscillation wavelength while the horizontal axis represents the injection current normalized with respect to the initial state.

Referring to FIG.11, the broken line designated as "a" represents the wavelength shift for the device wherein the parameter $\alpha$ is set to about 3.5 throughout the device while the one-dotted line designated as "b" represents the wavelength shift for the device wherein the parameter $\alpha$ is set to about 5.0. Further, the continuous line designated as "c" represents the wavelength shift for the device of the present embodiment wherein the parameter $\alpha$ is set to 3.5 at the region 13B. In the regions 13A and 13C, the parameter $\alpha$ is set to 5.0.

As will be seen clearly, the device of the present embodiment provides the largest shift of wavelength in response to the modulation of the injection current. Further, it should be noted that the device of the present embodiment provides a sharp spectrum in correspondence to the use of the reduced parameter $\alpha$ at the central region 13B of the laser diode. It will be noted that the device having the parameter $\alpha$ of 5.0 (curve b), the magnitude of shift of oscillation wavelength is comparable with the device of the present embodiment. In this device, however, it will be noted that the spectrum of the optical beam inevitably becomes diffuse because of the large value of the parameter $\alpha$.

The laser diode of FIG.8 may be fabricated by various processes. For example, one may deposit the InGaAsP layer in correspondence to the active layer 13 by the MBE process, and remove a part of the layer 13 in correspondence to the region 13B by an RIE process until the waveguide layer 12 is exposed. After covering the layer 13 by a silicon oxide mask in correspondence to regions 13A and 13C, the SCH layer $13B_3$ is deposited on the exposed part of the waveguide layer 12 by the MBE process. Further, the layers $13B_1$ and $13B_2$ are deposited alternately by the MBE process on the layer $13B_3$. After the layers $13B_1$ and $13B_2$ are repeated for a predetermined number of times, the SCH layer $13B_3$ is grown again and the formation of the layer 13 is completed. After the active layer 13 is thus formed, the clad layer 14 and the contact layer 15 are grown as usual and the electrodes 16 and 17 are provided. Further, the anti-reflection film 18 is formed on both longitudinal ends and the fabrication of the DFB laser diode is completed. As the formation of the waveguide layer 12 and the corrugation grating 11a is well known for example from the prior art reference cited at the introductory part of the present specification, further description of the fabrication process will be omitted.

Next, a second embodiment of the present invention will be described together with the fabrication process. First, the principle of the present embodiment will be described with reference to FIGS.12(A) and 12(B).

Referring to the drawings, FIG.12(A) shows a mask pattern 22 that is used for growing a semiconductor layer on a selected part of a substrate 21, while FIG.12(B) shows a profile of the thickness of the semiconductor layer grown on the substrate 21 by using the mask pattern 22. It will be noted that the mask pattern 22 includes two elongated parts, a first mask 22a and a second mask 22b extending generally parallel with each other with a separation W. More specifically, the masks 22a and 22b define therebetween a striplike region having a width set equal to W, and the deposition of the semiconductor layer occurs in correspondence to this strip-like region. Further, each of the masks 22a and 22b has a laterally projecting area $22a_1$ and $22b_2$ such that the areas $22a_1$ and $22b_2$ extend in the mutually opposing directions.

It should be noted that the masks 22a and 22b are formed of silicon oxide. When such a silicon oxide mask is used, it is known that the thickness of the epitaxial layer that is grown on the substrate in correspondence to the part that is located between the projecting areas $22a_1$ and $22a_2$ increases as compared with the part located between the straight parts of the masks 22a and 22b. See for example J. Finders et al., J. Crystal Growth, 107, pp.151-155 (1991). Although the reason of this phenomenon is not fully understood at the moment, it is believed that the atoms of the group III or group V element deposited on the masks 22a and 22b migrate on the surface of the mask and deposited when reached the exposed surface of the substrate 21. As the projecting areas $22a_1$ and $22b_1$ have an increased area as compared with other parts of the mask, the areas $22a_1$ and $22b_1$ collect larger number of atoms as compared with the rest of the part of the mask, and these atoms increase the thickness of the epitaxial layer at the part located between the parts $22a_1$ and $22b_1$ as shown in FIG.12(B).

Hereinafter, the fabrication process of the DFB laser diode of the present invention will be described with reference to FIGS.13(A) - 13(F). In the present embodiment, those parts that correspond to the parts described already with reference to previous embodiments will be designated by the same reference numerals and the description thereof will be omitted.

Referring to FIG.13(A), a silicon oxide layer 31 is provided on the waveguide layer 12 with a thickness of about 0.1 μm and patterned subsequently to form a mask pattern 32 as shown in the plan view of FIG.13(B). There, it will be seen that the mask pattern 32 includes a pair of generally parallel masks 32a and 32b, wherein the mask 32a has a laterally projecting area $32a_1$ and the mask 32b has a laterally projecting area $32b_1$.

Similarly to the mask 22 of FIG.12(A), the masks 32a and 32b are disposed symmetrically with each other, with the mask area $32a_1$ and the mask area $32b_1$ extending in the mutually opposite directions. Thereby, there is formed a strip-like region between the mask 32a and the mask 32b with a width W such that the upper major surface of the waveguide layer 12 is exposed at the strip-like region. It should be noted that the strip-like region is defined laterally by a pair of straight edges. In the illustrated example, the width W is set to 2 μm. Further, each of the masks 32a and 32b has a width A that is set to about 4 μm in correspondence to where there is no lateral projecting areas 32a and 32b, while each mask parts $32a_1$ and $32b_1$ has a width B of about 10 μm in correspondence to the parts $32a_1$ and $32_2$. It should be noted that the parts $32a_1$ and $32b_1$ correspond to the region 13B defined in FIG.8 while the rest of the part of the masks 32a and 32b corresponds to the regions 13A and 13C of the laser diode. See FIG.13(B).

By using the mask 32, the deposition of an active layer 13' corresponding to the active layer 13 of FIG.8 is made by the metal organic vapor phase epitaxy (MOVPE) process by alternately depositing a quantum well layer 13a' of InGaAsP and a barrier layer 13b' of InGaAs, wherein the barrier layer 13b' is deposited first on the upper major surface of the waveguide layer 12. See FIG.13(C). There, the gases such as TMI, TMG, arsine and phosphine are introduced into a reaction vessel as the source of the layer 13a', while the gases such as TMI, TMG and arsine are introduced as the source of the layer 13b'.

For the growth of the layer 13a', the gases TMI, TMG, arsine and phosphine are introduced with respective flowrates of 0.5 SCCM, 0.5 SCCM, 0.5 SCCM and 0.5 SCCM. On the other hand, the growth of the layer 13b' is made while introducing the gases TMI, TMG and arsine with respective flowrates of 0.5 SCCM, 0.5 SCCM and 0.5 SCCM. Thereby, one obtains the thicknesses of 5 nm and 8 nm for the layers 13a' and 13b' in the regions 13A and 13C, while the layers 13a' and 13b' thus grown in the region 13B have the thicknesses of 7 nm and 11 nm.

As a result of the repetitive deposition of the layers 13a' and 13b', one obtains a structure as shown in FIG.13(D) wherein the thickness of the layer 13' is increased in correspondence to the region 13B as compared with the regions 13A and 13C. After the layers 13a' and 13b' are stacked for five repetitions for example, the layer 13' has a thickness of about 57 nm in correspondence to the region 13B while the layer 13' has the thickness of about 79 nm in correspondence to the regions 13A and 13C.

After the structure of FIG.13(D) is obtained, the silicon oxide masks 33a and 33b are removed by etching such as a wet etching process in a hydrofluoric acid, and the clad layer 14 is deposited on the structure thus obtained by the MOVPE process. Further, the contact layer 15 is grown on the clad layer 14, and the electrodes 16 and 17 are provided respectively on the upper major surface of the contact layer 15 and the lower major surface of the substrate 11 as usual.

When providing the electrode 16, one may provide an insulating layer such as silicon oxide on the upper major surface of the contact layer 15 and pattern the same into a first part 16a and a second part 16b extending parallel with each other in the longitudinal direction of the laser diode. There, the upper major surface of the contact layer 15 is exposed in correspondence to the strip-like region extending in the longitudinal direction of the laser diode between the parts 16a and 16b, and the electrode 16 establishes a contact with the contact layer 15 in correspondence to the exposed part of the layer 15. Thereby, one can obtain a lateral confinement of the injection current as usual in the laser diodes.

In the DFB laser diode of the present invention, it should be noted that the increased thickness of the quantum well layers 13'a increases the wavelength of the optical radiation that is produced as a result of recombination of the carriers in the region 13B. Thereby, the optical radiation produced in the region 13B of the laser diode has a wavelength that is deviated from the wavelength of the optical radiation that is produced in the regions 13A and 13C in the longer wavelength side. On the other hand, the corrugation grating 11a is tuned to cause the Bragg reflection for the optical radiation produced in the first and third regions 13A and 13C. When such a deviation exists, it is well known that the differential gain dG/dN increases and the linewidth enhancement factor α decreases correspondingly. See for example S. Ogita et al., Electronic Letters, 23, pp.393 - 394, 1987, which is incorporated herein as reference. Thus, the DFB laser diode of the present embodiment also shows the distribution of the linewidth enhancement factor α as shown in FIG.7.

In the present embodiment, it should be noted that the active layer 13' can be grown without interrupting the growth process except for the formation of the mask 32. The process such as etching a part of the active layer 13 in correspondence to the region 13B and forming the quantum well in correspondence to the etched part as in the case of the first embodiment can be eliminated. Thereby, the active layer 13' can be grown without substantial defects, and the laser diode operates with improved efficiency.

FIG.14 shows a third embodiment of the present invention wherein the present invention is applied to the DFB laser diode that has three separated electrodes 15A, 15B and 15C instead of the single electrode 15 of the previous embodiments. Other parts of the laser diode is constructed substantially identical with the previous embodiments, for example the second embodiment. Thereby, the laser diode has the distribution of the linewidth enhancement factor $\alpha$ similar to FIG.7.

FIG.15 shows the distribution profile of the refractive index n in the longitudinal direction of the laser diode. In this case, too, the change of the refractive index in the reverse direction in correspondence to the region 13B is effectively suppressed, and the laser diode shows a large shift of oscillation wavelength in response to the modulation of the injection current.

In the description heretofore, it is needless to say that the structure of the laser diode is not limited to those described. For example, the waveguide layer 12 may be provided above the active layer 13 or 13', with the corrugation grating 11a formed on the upper major surface of the waveguide layer 12. Further, the substrate 11 may include one or more buffer layers for improvement of quality of the crystal of the active layer. As these modifications are obvious for the person skilled in the art, further description thereof or illustration will be omitted.

Further, the localized decrease of the parameter $\alpha$ may be achieved by forming the active layer by a single MQW structure and increasing the total thickness of the MQW structure in correspondence to the central region 13B similar to the case of FIG.13(D). In this case, the number of quantum wells included in the MQW structure is increased in the region 13B as compared with the regions 13A and 13C. In this construction, too, the differential gain dG/dN increases in correspondence to the region 13B. As the construction of this modification is obvious from FIG.13(D) further description will be omitted. Further, one may form the active layer from a single MQW structure and erase the quantum well structure by implanting impurities such as Zn in correspondence to the regions 13A and 13C.

## Claims

1. A distributed feedback laser diode, comprising:
   an active layer (13, 13') having upper and lower major surfaces and extending in a first direction between a first end and a second end, said active layer being supplied with carriers of first and second types for producing an optical beam as a result of a recombination of the carriers, said active layer having a linewidth enhancement factor; a waveguide layer (12) having upper and lower major surfaces and provided adjacent to said active layer for guiding said optical beam therethrough in said first direction; corrugation means (11a) provided on the waveguide layer for causing a Bragg reflection in the optical beam that is guided in the waveguide layer, said corrugation means comprising a first corrugation part characterized by a first pitch and a first phase, a second corrugation part characterized by a second pitch identical with the first pitch and a second phase, and a phase shift point (11A) formed at a boundary between said first corrugation part and said second corrugation part, said phase shift point causing a shift of the second phase with respect to the first phase by an amount equal to a quarter of the first pitch;
   a first semiconductor layer (11) of a semiconductor material having upper and lower major surfaces and provided below any of the active layer, the waveguide layer and the corrugation means, said first semiconductor layer being doped to a first conductivity type for supplying the carriers of the first type to said active layer; a second semiconductor layer (14) of a semiconductor material having upper and lower major surfaces and provided above any of the active layer, the waveguide layer and the corrugation means, said second semiconductor layer being doped to a second conductivity type for supplying the carriers of the second type; first electrode means (17) provided on the lower major surface of the first semiconductor layer for injecting the carriers of the first type into said first semiconductor layer; and second electrode means (15, 16) provided on the upper major surface of the second semiconductor layer for injecting the carriers of the second type into said second semiconductor layer;
   characterized in that:
   said active layer is formed of a first region (13A), a second region (13B) and a third region (13C) aligned in the first direction such that the first region and third region are located at both sides of the second region in said first direction, said second region being further formed in correspondence to said phase shift point of the corrugation means, said first region, said second region and said third region having first, second and third profiles of the linewidth enhancement factor respectively, wherein the linewidth enhancement factor in the second profile is smaller than the linewidth enhancement factor of said first and third profiles, and wherein said linewidth enhancement factor changes stepwise at a boundary between the first region and the second region and at a boundary between the second region and the third region.

2. A distributed feedback laser diode as claimed in claim 1 characterized in that said first and third regions (13A, 13C) of the active layer comprises a bulk crystal of a semiconductor material, while said second region of the active layer comprises an alternate stacking of a quantum well layer ($13B_1$) of a first semiconductor material having a first band gap and a barrier layer ($13B_2$) of a second semiconductor material having a second band gap substantially larger than said first band gap, wherein each of said quantum well layer has a thickness set such that there are formed discrete quantum levels (QL, QL') in the quantum well layer.

3. A distributed feedback laser diode as claimed in claim 2 characterized in that said first material comprises InGaAsP while said second material comprises InGaAs.

4. A distributed feedback laser diode as claimed in claim 1 characterized in that said active layer (13') comprises a quantum well layer ($13B_1$) of a first semiconductor material having a first band gap and a barrier layer ($13B_2$) of a second semiconductor material having a second band gap that is substantially larger than the first band gap, said quantum well layer having a thickness set such that there are formed discrete quantum levels, said quantum well layer and said barrier layer being stacked alternately to form said active layer, wherein said quantum well layer has an increased thickness in correspondence to said second region (13B) of the active layer as compared with said first and third regions (13A, 13C).

5. A distributed feedback laser diode as claimed in claim 1 characterized in that said active layer (13') comprises a quantum well layer ($13B_1$) of a first semiconductor material having a first band gap and a barrier layer ($13B_2$) of a second semiconductor material having a second band gap that is substantially larger than the first band gap, said quantum well layer having a thickness set such that there are formed discrete quantum levels, said quantum well layer and said barrier layer being stacked alternately to form said active layer, wherein said active layer (13') has an increased thickness in correspondence to said second region as compared with said first and third regions.

6. A distributed feedback laser diode as claimed in claim 5 characterized in that said second region (13B) of said active layer (13') includes a number of said quantum well layers that is larger than said first and third regions (13A, 13C).

7. A method for fabricating a distributed feedback laser diode, said laser diode having an active layer (13') extending in a first direction, said active layer comprising a first region (13A), a second region (13B) and a third region (13C) aligned in said first direction;
   characterized in that the method comprises the steps of:
   providing a mask layer on a principal surface of a semiconductor layer (12) on which said active layer is to be formed;
   patterning the mask layer to form a mask pattern (32) such that the mask pattern comprises a pair of elongated mask parts (32a, 32b) extending in said first direction generally with a parallel relationship with each other, each of said mask parts having a laterally projecting area ($32a_1$, $32b_1$) in correspondence to said second region of the active layer and disposed symmetrically with respect to the other mask part about a hypothetical axis that extends in said first direction; and
   growing a multiple quantum well structure on said principal surface while using said mask pattern as a mask, said step of growing the multiple quantum well structure comprising an alternate deposition of a quantum well layer ($13B_1$) having a first band gap and a barrier layer ($13B_2$) having a second band gap that is larger than said first band gap.

8. A method as claimed in claim 7 characterized in that said step of alternate deposition of the quantum well layer ($13B_1$) and the barrier layer ($13B_2$) is achieved by using an organic source material.

9. A method as claimed in claim 8 characterized in that said step of alternate deposition of the quantum well layer ($13B_1$) and the barrier layer ($13B_2$) is achieved by a metal organic vapor phase epitaxy process.

10. A method as claimed in claim 7 characterized in that said step of depositing the mask layer comprises a step of depositing a silicon oxide layer as the mask layer.

# FIG. 1 ( PRIOR ART )

# FIG. 2 ( PRIOR ART )

# FIG. 3 (PRIOR ART)

# FIG. 4 (PRIOR ART)

## FIG. 5 (PRIOR ART)

## FIG. 6 (PRIOR ART)

# FIG. 7

# FIG. 8

## FIG. 9

## FIG. 10

# FIG. 11

# FIG. 12 (A)

# FIG. 12 (B)

FIG.13(A)

31
12
11

11A

FIG.13(B)

32        32a₁

A        12

B        32a

W        32b

B        32b₁

A

13A        13B        13C

## FIG. 13(C)

## FIG. 13(D)

FIG. 13 (E)

FIG. 13 (F)

# FIG. 14

# FIG. 15